# EUROPEAN PATENT APPLICATION

(11) **EP 1 908 861 A1**
(43) Date of publication of application: **09.04.2008**
(21) Application number: 05767033.3
(22) Date of filing: 27.07.2005
(51) Int. Cl.: C30B 29/06, C30B 30/04

(54) **SILICON SINGLE CRYSTAL PULLING APPARATUS AND METHOD THEREOF**

(71) Applicant: SUMCO Corporation, Tokyo 105-8634 (JP)
(72) Inventor: FU, Senlin, c/o SUMCO CORPORATION, Tokyo 105-8634 (JP); ONO, Naoki, c/o SUMCO CORPORATION, Tokyo 105-8634 (JP)
(74) Representative: Bertsch, Florian Oliver
(86) International application number: PCT/JP2005/013715
(87) International publication number: WO 2007/013148

(57) **Abstract**

A quartz crucible which stores a silicon melt is rotated at a predetermined rotation speed, and a silicon single crystal ingot pulled from the melt is rotated at a predetermined rotation speed. A first coil and a second coil are installed with a predetermined spacing in between such that a center of each of the coils corresponds to a rotation center of the crucible. A magnetic field is generated by energizing electric currents in the first and second coils in the same direction. The first coil is installed outside the chamber and the second coil is installed inside the chamber. A center position of the predetermined spacing between the first coil and the second coil is controlled at the same or a lower level as the surface of the silicon melt such that a distance of the center position from the surface of the silicon melt is 0 mm or more and 10000 mm or less.

## Description

### TECHNICAL FIELD

The present invention relates to an apparatus for pulling a silicon single crystal ingot from a silicon melt while applying a vertical magnetic field to the silicon melt.
The present invention also relates to a method of pulling the silicon melt.

### BACKGROUND ART

Conventionally, the Czochralski method (hereafter referred to as CZ method) has been known as a method of growing a silicon single crystal ingot. In the CZ method, high purity silicon single crystal ingot for a semiconductor is grown from a silicon melt stored in a crucible. In the CZ method, a mirror-etched seed crystal is made to contact the silicon melt. Subsequently, a silicon single crystal ingot is grown by pulling the seed crystal while rotating the seed crystal. In this method of growing a silicon single crystal, after forming a seed drawing portion by pulling the seed crystal, a shoulder portion is formed by gradually increasing the diameter of the crystal to a target diameter of the silicon single crystal ingot, and a straight body portion of the silicon single crystal ingot is formed by further pulling the crystal.

On the other hand, a silicon single crystal includes impurities. For example, the impurities may be constituted of dopants such as boron and phosphorus that are intentionally added to the crystal so as to control the electric resistivity, and oxygen which is dissolved from a wall of the quartz crucible into the silicon melt during the pulling process and contaminates in the single crystal ingot. When the silicon single crystal ingot is used for forming silicon wafers, those impurities have an influence on the qualities of the wafers. Therefore, the impurities must be controlled properly. In particular, it is important to control the radial distribution of impurities in the silicon single crystal ingot to have an uniform distribution in order to form a wafer having a uniform in-plane distribution of impurities. In a recently used technique (MCZ method: Magnetic Field Applied Czochraski Method), based on the consideration of the above-described problem, a static magnetic field is applied to a melt in the crucible while pulling a single crystal in accordance with the Czochraski Method so as to control thermal convection of the silicon melt. In general, three types of magnetic fields, i.e., a horizontal magnetic field (e.g., Patent Reference 1: Japanese Unexamined Patent Application, first Publication, No. S61-239605), a vertical magnetic field (e.g., Patent Reference 2: Japanese Unexamined Patent Application, First Publication, No. H10-279380), and a cusp magnetic field (e.g., Patent Reference 3: Japanese Unexamined Patent Application, First Publication No. 2003-2782) are known as the static magnetic field. The MCZ method has proved to be effective in stabilizing the temperature of the silicon met by controlling the convention of the silicon melt, and in decreasing dissolution of the crucible caused by the melt.

### [Problem to be solved by the invention]

However, in the case of the horizontal magnetic field, in the surface or the arbitrarily selected horizontal section of the silicon melt, it is impossible to apply a uniform magnetic field in the rotational angle. Where electromagnets are installed so as to apply a transverse magnetic filed on a horizontal plane in one direction, and thereby generating a magnetic field directed from one electromagnet to another electromagnet, distribution of the magnetic field in a direction parallel to the application direction is largely different from the distribution of the magnetic field vertical to the application direction. In addition, the magnetic filed has the highest strength in a central portion of the silicon melt, and the strength is decreased in accordance with increasing distance from the central portion. As a result, it is impossible to apply a axisymmetric magnetic field around the central axis of the silicon melt.

A vertical magnetic field is applied from a first coil and a second coil having the same diameter which is larger than the outer diameter of the quartz crucible. The first and second coils are installed with a predetermined spacing in between in the vertical direction, and the center of each coil is adjusted to the rotational axis of the quartz crucible. Therefore, by the vertical magnetic field generated from the first and second coils, it is possible to apply a axisymmetric magnetic field uniformly to the silicon melt. However, in the case of the vertical magnetic field, it is impossible to prevent the impurities (for example, oxygen which is dissolved from the wall of the quartz crucible and is contaminated in the melt) from concentrating at the central portion of the surface of the silicon melt, since the convection of the silicon melt is controlled by Lorentz force generated by the magnetic filed. Therefore, there has been a problem that oxygen as an impurity contaminated the silicon single crystal ingot by being captured from the central portion of the surface of the silicon melt.

On the other hand, a cusp magnetic field is generated by installing a first coil and a second coil having the same diameter which is larger than the outer diameter of the quartz crucible such that the first and the second coils are placed with a predetermined spacing in between in the vertical direction, and the center of each coil is adjusted to the rotation axis of the quartz crucible, and energizing electric currents in opposite directions in the first and the second magnetic coils. Therefore, in the cusp magnetic field, a transversal magnetic field is applied to the silicon melt in the vicinity of the inner peripheral surface of the quartz crucible. As a result, it is possible to inhibit impurities, e.g., oxygen which is dissolved from the wall of the crucible and is contaminated in the silicon melt, concentrating to the central portion of the surface of the silicon melt and being captured by the silicon single crystal ingot. However, since the strength of the cusp magnetic filed is zero in the vicinity of the solid-liquid interface beneath the silicon single crystal ingot, there has been a problem that the shape of solid-liquid interface cannot be controlled by the magnetic field. Especially, under the recent trend for controlling a shape of solid-liquid interface to attempt at growing silicon single crystal ingot which is free of aggregates of interstitial silicon type point defects in the interior, importance for controlling the shape of the solid-liquid interface is increasing.
An object of the present invention is to provide an apparatus and a method for growing a silicon single crystal which enables the application of a uniform magnetic field to a silicon melt axisymmetrically around the central axis of the silicon melt, preventing concentration of impurities such as oxygen to the central portion of the surface of the silicon melt, and effectively controlling the shape of the solid-liquid interface directly beneath the silicon single crystal ingot.

### DISCLOSURE OF INVENTION

### Problem to be solved by the invention

In an apparatus for pulling a single crystal according to the present invention, during pulling a silicon single crystal from a silicon melt while rotating the single crystal at a predetermined rotation speed and rotating a quartz crucible which is installed in a chamber and stores the silicon melt at a predetermined rotation speed, a first coil and a second coil are installed with a predetermined spacing in between in the vertical direction such that the center of each coil is adjusted to the rotation axis of the quartz crucible. A magnetic field is generated between the first and the second coils by energizing electric current in each of the first coil and the second coil in the same direction. In the present invention, a single crystal pulling apparatus of the above-described configuration is improved by a constitution such that the first coil is installed outside the chamber and the second coil is installed inside the chamber.

In the above-described apparatus for pulling a silicon single crystal, when electric currents of the same direction are energized in the first and the second coils, the magnetic line of flux of the magnetic field generated by the currents shows a cone-like shape such that a diameter of a profile of the magnetic line of the flux observed from a transverse direction decreases in a downward direction. In this cone-shaped magnetic field, a magnetic field directed to a central portion of the silicon melt is applied uniformly. As a result, it is possible to apply to the silicon melt, a uniform magnetic field which is axisymmetric about the center axis of the silicon melt.
The cone-shaped magnetic filed has properties both of the vertical magnetic field and the transverse magnetic field. By a transverse component of the magnetic field, impurities such as oxygen dissolved from the wall of the crucible and contaminated in the melt are prevented from concentrating at the central portion of the melt surface. Therefore, contamination of the silicon single crystal ingot by the oxygen impurity can be reduced sufficiently.
The strength of the cone-shaped magnetic field is not reduced to zero in the vicinity of the solid-liquid interface directly beneath the silicon single crystal ingot. Therefore, the shape of the solid-liquid interface can be controlled by the magnetic field.

The above-described apparatus for pulling a silicon single crystal may have a constitution such that: a vertical spacing between the first and second coils is greater than 0 and less than or equal to 10000 mm; the diameter D₁ of the first coil is 100 mm or more and 10000 mm or less; the diameter D₂ of the second coil is 5 mm or more and 5000 mm or less; the proportion of the diameter D₁ of the first coil to the diameter D₂ of the second coil is 1 or more and 2000 or less; and a difference between the diameter D₁ of the first coil and the diameter D₂ of the second coil is 2t or more, where t is the thickness of a circumferential wall of the chamber.
In the above-described apparatus for pulling a silicon single crystal, it is possible to effectively control the strength of the magnetic field in the vicinity of the solid-liquid interface directly beneath the silicon single crystal ingot. By this magnetic field, the shape of the solid-liquid interface is effectively controlled. Preferably, T may be greater than 0 and less than or equal to 8000 mm, the diameter D₁ of the first coil may be 500 mm or more and 5000 mm or less, and the diameter D₂ of the second coil may be 50 mm or more and 500 mm or less.

In a method of pulling a silicon single crystal according to the present invention, during pulling a silicon single crystal from a silicon melt while rotating the single crystal at a predetermined rotation speed and rotating a quartz crucible which is installed in a chamber and stores the silicon melt at a predetermined rotation speed, a first coil having a coil diameter which is larger than a diameter of the chamber is installed outside the chamber such that a center of the coil corresponds to a rotation axis of the quartz crucible, and a second coil is installed inside the chamber with a predetermined spacing in the vertical direction from the first coil such that a center of the second coil corresponds to the rotation axis of the quartz crucible, and a magnetic field is generated between the first and the second coils by energizing the electric current in each of the first coil and the second coil in the same direction.

In the above-described single crystal pulling method, a center (half) position of the predetermined spacing T between the first coil and the second coil is controlled to be at the same or a lower level as the surface of the silicon melt such that 0 mm ≤|H| ≤ 10000 mm is satisfied, where H is the distance of the center position from the surface of the silicon melt.
In the above-described method of pulling a silicon single crystal, by pulling a silicon single crystal while controlling the center position to at the same or a lower level as the surface of the silicon melt such that the distance of the center position from the surface of the silicon melt satisfies 0 mm ≤|H| ≤ 10000 mm, a predetermined convection is generated in the silicon melt. By this convection, the solid-liquid interface which has largely had a downwardly convex shape in the prior art takes a nearly flat shape at the same level as the melt surface. As a result, axial thermal gradient in the silicon single crystal shows nearly constant values in the radial distribution, and it is possible to grow relatively easily a silicon single crystal which is of high quality and is defect free throughout nearly the whole length. Where |H| exceeds 10000 mm, it is difficult to control the oxygen and the shape of the solid-liquid interface because of insufficient strength (magnetic flux density) of the magnetic field in the melt. As a preferable range, 0 mm ≤ | H | ≤ 500 mm may be satisfied.

In the above-described method of pulling a single crystal, where I₁ denotes the current energized in the first coil and I₂ denotes the current energized in the second coil, magnetic flux density may be controlled to be 0.001 to 0.1T (Wb/m²) at a position within the inner diameter of the quartz crucible at the same level as the center position by energizing electric currents in the first coil and the second coil such that I₁ and I₂ are controlled in the range from 0.1 to 10³⁰ A and satisfy 0.001 ≤ (I₁/I₂) ≤ 1.
In the above-described method of pulling a silicon single crystal, it is possible to control the strength of the magnetic field in the vicinity of the solid-liquid interface directly beneath the silicon single crystal ingot effectively, thereby producing a silicon single crystal ingot that does not include aggregates of interstitial silicon type point defects in the interior. Where the magnetic flux density at the position within the inner diameter of the quartz crucible at the same level as the center position is lower than 0.001 T (Wb/m²), oxygen cannot be controlled sufficiently because of insufficient strength (magnetic flux density) of the magnetic field in the melt. Where the magnetic flux density at the position within the inner diameter of the quartz crucible at the same level as the center position exceeds 1.0 T (Wb/m²), the shape of the solid-liquid interface cannot be controlled sufficiently because of insufficient development of the shape of the solid-liquid interface. Preferably, I₁ and I₂ may be within the range from 100 to 10¹⁰ A, and the magnetic flux density at the position within the inner diameter of the quartz crucible at the same level as the center position may be in the range from 0.01 to 0.5 T (Wb/m²).

### Effect of the invention

In the apparatus for pulling a silicon single crystal according to the present invention, since the first coil is installed outside the chamber and the second coil is installed inside the chamber, by energizing electric currents in the first and the second coils in the same direction, it is possible to apply a cone-shaped magnetic field such that a diameter of a profile of the magnetic line of the flux observed from a transverse direction decreases towards a downward direction. In the cone-shaped magnetic field, the magnetic field directed to the center portion of the silicon melt is applied uniformly. As a result, it is possible to apply a uniform magnetic field that is axisymmetric about the central axis of the silicon melt. The cone-shaped magnetic field has properties of a vertical magnetic field and a transverse magnetic field. By the horizontal component of the magnetic field, impurities such as oxygen dissolved from the wall of the crucible and contaminated in the melt are prevented from concentrating to the central portion of the melt surface. Moreover, since the strength of the cone-shaped magnetic field is not reduced to zero even in the vicinity of solid-liquid interface directly beneath the silicon single crystal ingot, it is possible to use the cone-shaped magnetic field for controlling the shape of the solid-liquid interface.

In the method of pulling a silicon single crystal according to the present invention, a center (half) position of the predetermined spacing T between the first coil and the second coil is controlled to be at the same or a lower level as the surface of the silicon melt such that 0 mm ≤ | H | ≤ 10000 mm is satisfied, where H is the distance of the center position from the surface of the silicon melt. Therefore, a predetermined convection is generated in the silicon melt. By this convection, the solid-liquid interface which has largely had a downwardly convex shape in the prior art takes a nearly flat shape at a same level as the melt surface. As a result, axial thermal gradient in the silicon single crystal shows nearly constant values in radial distribution, and it is possible to relatively easily grow a silicon single crystal which is of high quality and is defect free throughout nearly the whole length. At that time, where I₁ denotes the current energized in the first coil and I₂ denotes the current energized in the second coil, by controlling magnetic flux density to be 0.001 to 0.1 T (Wb/m²) at the position within the inner diameter of the quartz crucible at the same level as the center position by energizing electric currents in the first coil and the second coil such that I₁ and I₂ are controlled in the range from 0.1 to 10³⁰ A and satisfy 0.001 ≤ (I₁/I₂) ≤ 1, it is possible to effectively control the strength of the magnetic field in the vicinity of the solid-liquid interface directly beneath the silicon single crystal ingot effectively, thereby producing a silicon single crystal ingot having interior structure that is free of aggregates of interstitial silicon type point defects.

### BRIEF DESCRIPTION OF THE DRAWINGS

FIG. 1 is a schematic diagram showing a constitution of an apparatus for pulling a silicon single crystal according to the present embodiment.
FIG. 2 is a enlarged view showing a relation between coils and a crucible in the apparatus of FIG. 1.
FIG. 3 is a sectional view along the line A-A in FIG. 2 and shows directions of the magnetic field applied to the silicon melt in the crucible.
FIG. 4 is a graph based on Voronkov's theory showing that vacancy type point defects are dominant in a ingot formed where V/G ratio is not lower than a critical point, and that interstitial silicon type point defects are dominant in an ingot formed where V/G ratio is not higher than a critical point.

### EXPLANATION OF SYMBOLS

- 11: chamber
- 12: silicon melt
- 13: quartz crucible
- 25: silicon single crystal ingot
- 41: first coil
- 42: second coil
- 43: magnetic field
- 43a: center position between the first coil and the second coil
- H: distance of the center position of the predetermined spacing T from the surface of the silicon melt
- D1: diameter of the first coil
- D2: diameter of the second coil
- T: predetermined spacing
- t: thickness of the circumferential wall of the chamber

### BEST MODE FOR CARRYING OUT THE INVENTION

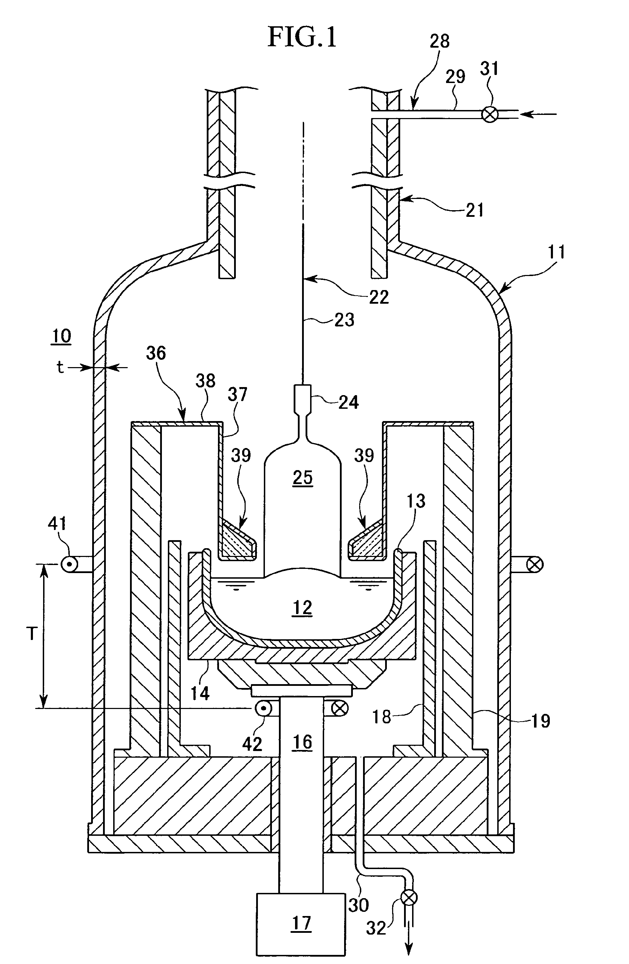

Next the best mode for carrying out the invention is explained with reference to the drawings. However, it should be noted that the present invention is not limited to the below-described embodiments.
An apparatus 10 for pulling a silicon single crystal according to the present invention is shown in FIG. 1. A quartz crucible 13 that stores a silicon melt 12 is installed in a chamber 11 of the apparatus 10. The outer periphery of the quartz crucible 13 is covered by a graphite susceptor 14. A bottom face of the quartz crucible 13 is fixed on the upper end of the support shaft 16 via the graphite susceptor in between, and the lower end of the support shaft 16 is connected to a crucible driving unit 17. Although they are not illustrated in the drawing, a first rotating motor for rotating the quartz crucible 13 and an elevating motor for driving the quartz crucible up and down are equipped to the crucible driving unit 17. By these motors, the quartz crucible can be rotated in a predetermined direction, and can be driven upward and downward. The outer periphery of the quartz crucible 13 is surrounded by a heater with a predetermined spacing in between. The heater 18 is surrounded by a heat insulating cylinder 19.
High purity polycrystalline silicon materials installed in the quartz crucible 13 are heated and molten by the heater 18 into a silicon melt 12.

A cylindrical casing 21 is connected to the upper end of the chamber 11. A pulling unit 22 is provided to the casing 21. The pulling unit 22 comprises a pulling head (not shown) which is provided to the upper end of the casing 21 and is tunable at a horizontal state, a second rotating motor (not shown) for rotating the pulling head, a wire cable 23 which is suspended from the head towards the rotation center of the quartz crucible 13, and a pulling motor (not shown) for winding and unwinding the wire cable 23. A seed crystal 24 which is to be dipped in the silicon melt 12 for pulling the silicon single crystal ingot 25 is attached to the lower end of the wire cable 23.
A gas supply/exhaustion unit 28 for supplying an inert gas to the silicon single crystal side in the chamber 11 and exhausting the inert gas from the crucible inner periphery side in the chamber 11 is connected to the chamber 11. The gas supply/exhaustion unit 28 comprises a supply pipe 29 one end of which is connected to the circumferential wall of the casing 21 and another end of which is connected to a tank (not shown) that stores the above-described inert gas, and an exhaustion pipe 30 one end of which is connected to a bottom wall of the chamber 11 and another end of which is connected to a vacuum pump (not shown). A first flow control valve 31 and a second flow control valve are respectively provided to the supply pipe 29 and the exhaustion pipe 30 so as to control flow rates of the inert gas flowing in the pipes 28, 30.

An output axis of the pulling motor (not shown) is provided with an encoder (not shown). A crucible driving unit 17 is provided with an encoder (not shown) for detecting the elevated position of the support shaft. Each detection output of the two encoders is connected to a controlling input of a controller (not shown) and controlling outputs of the controller are respectively connected to the pulling motor of the pulling unit 22 and the elevating motor of the crucible driving unit 17. The controller is provided with a memory (not shown). A winding length of the wire cable 23 corresponding to the detection out put of the encoder, that is a pulling length of the silicon single crystal ingot 25 is stored as a first map in the memory. A surface level of the silicon melt 12 in the crucible 13, corresponding to the pulling length of the silicon single crystal ingot 25, is recorded as a second map in the memory. Based on the detection output of the encoder in the pulling motor, the controller controls the elevating motor of the crucible driving unit 17 such that the melt surface of the silicon melt 12 in the quartz crucible 13 is maintained at a constant level.

A heat shielding member 36 surrounding the outer periphery of the silicon single crystal ingot 25 is provided between the outer periphery of the silicon single crystal ingot 25 and the inner periphery of the quartz crucible 13. The heat insulating member is constituted to have a cylindrical shape, and comprises a cylinder portion 37 that blocks the heat radiation from the heater 18, and a flange portion 38 that is connected to an upper edge of the cylinder portion 37 and nearly horizontally extends to the outward direction. By placing the above-described flange portion 38 on the heat insulating cylinder 19, the heat shielding member 36 is fixed inside the chamber 11 such that the bottom edge of the cylinder portion 37 is positioned above the surface of the silicon melt 12 with a predetermined distance in between. A protruding portion 39 protruding towards the inside on the cylinder is provided to the lower part of the cylinder portion 37.

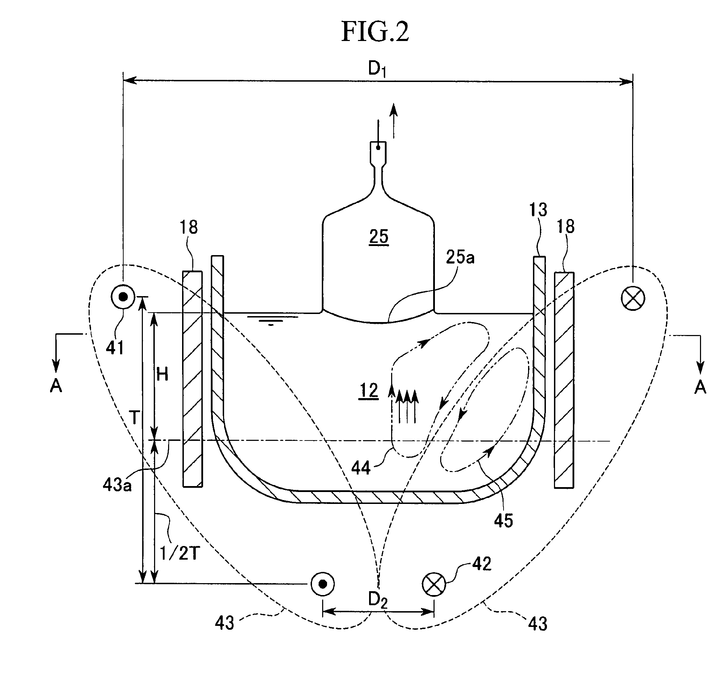

In the pulling apparatus, a first coil 41 and a second coil 42 each having a center corresponding to the rotational axis of the quartz crucible 13 are installed with a predetermined spacing T in between in the vertical direction. The first coil 41 is installed outside the chamber 11 and the second coil 42 is placed inside the chamber 11. As shown in FIG. 2, the vertical spacing T between the first coil 41 and the second coil 42 is 0 or more and 10000 mm or less. A diameter D₁ of the first coil 41 is 100 mm or more and 10000 mm or less. A diameter D₂ of the second coil 42 is 5 mm or more and 5000 mm or less. The first coil 41 and the second coil 42 are installed such that a proportion of the diameter D₁ of the first coil 41 to the diameter D₂ of the second coil 42 is 1 or more and 2000 or less, and a difference between the diameter D₁ of the first coil 41 and the diameter D₂ of the second coil 42 is 2t or more, where t denotes a thickness of the circumferential wall of the chamber 11 (FIG. 1). The pulling apparatus 10 is constituted such that the single crystal ingot 25 is pulled while generating a magnetic field 43 between the first coil 41 and the second coil 42 by energizing electric currents in the first and the second coils 41, 42 in the same direction.

Next, a pulling method using the apparatus for pulling a silicon single crystal is explained.
A silicon single crystal ingot 25 is pulled from the silicon melt 12 while rotating the quartz crucible 13 that stores the silicon melt 12 at a predetermined rotation speed R₁, rotating a silicon single crystal ingot 25 being pulled from the silicon melt at a predetermined rotation speed R₂, and applying the magnetic filed 43 to the silicon melt 12 using the first and the second coils 41, 42.
As shown in FIG. 2, the first coil is installed outside the chamber 11 and the second coil is installed inside the chamber 11. Therefore, when electric currents in the same direction are energized in the first and the second coils 41, 42, the magnetic field 43 generated by the first and the second coils 41, 42 shows a cone-like shape such that a diameter of a profile of the magnetic line of the flux observed from a transverse direction decreases in a downward direction.

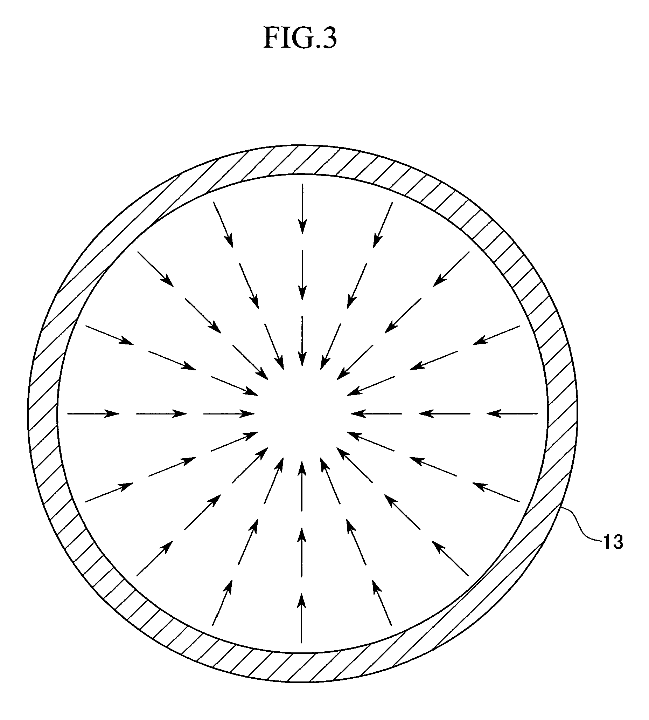

A state of the magnetic field 43 in a horizontal sectional plane of the silicon melt applied with the above-described cone-shaped magnetic field is shown in FIG.3. As it is clear from FIG. 3, a magnetic field directed to the central portion of the melt is applied uniformly to the silicon melt. As a result, a uniform magnetic field that is axisymmetric about the central axis of the melt is applied uniformly to the melt. The cone-shaped magnetic field has properties of both a vertical magnetic field and a transverse magnetic field. By the transverse component, it is possible to prevent the central portion of the surface of the silicon melt from concentrating impurities such as oxygen dissolved from the wall of the quartz crucible and contaminated in the silicon melt. As a result, contamination of the silicon single crystal ingot 25 by the oxygen as an impurity can be reduced sufficiently.

The strength of the cone-shaped magnetic field is not reduced to zero even in the vicinity of the solid-liquid interface directly beneath the silicon single crystal ingot. Therefore, it is possible to control the shape of the solid-liquid interface. By pulling the silicon single crystal with a pulling rate profile in accordance with Voronkov's theory, it is possible to produce a silicon single crystal ingot having no interstitial silicon type point defects in the interior portion. In the Voronkov's theory, where V (mm/minute) denotes the pulling rate of the silicon single crystal ingot, and G (°C/mm) a thermal gradient in the silicon single crystal ingot in the vicinity of the interface between the silicon single crystal ingot and the silicon melt 12, V/G (mm²/minute•°C) is controlled in order to grow a high purity silicon single crystal ingot 25 having small number of defects.

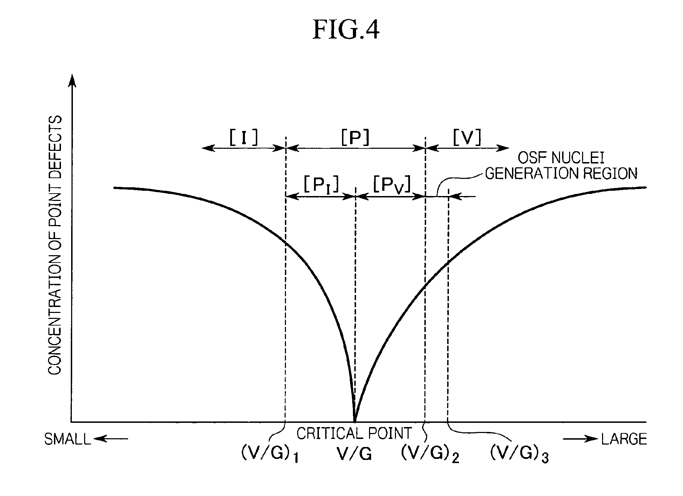

In the Voronkov's theory, the relationship between V/G and concentration of point defects is graphically represented. For example, in FIG. 4, V/G is plotted along the horizontal axis and concentration of vacancy type point defects and concentration of interstitial silicon type point defects are plotted along the same vertical axis. Using such a graph, Vornkov's theory explains that a boundary position between vacancy region and interstitial silicon region is determined by V/G. Specifically, vacancy type point defect-dominant silicon single crystal ingot is formed where V/G ratio is not lower than the critical point (critical value), and interstitial silicon type point defect-dominant silicon single crystal ingot is formed where V/G ratio is not higher than the critical point. In FIG. 4, [1] denotes a region ((V/G) ₁ or less) in which interstitial silicon type point defects are dominant and aggregates of the interstitial silicon type point defects exist, and [V] denotes a region ((V/G)₂ or more) in which vacancy type point defects are dominant in the silicon single crystal ingot and aggregates of the vacancy type point defects exist, and [P] denotes a perfect region ((V/G)₁ to (V/G)₂) in which aggregates of vacancy type point defects and aggregates of interstitial silicon type point defects do not exist. A region [V] (((V/G)2 to (V/G)₃) adjacent to the region [P] is a region for forming OSF nuclei.

The perfect region [P] is further divided to a region [P_{I}] and a region [P_{V}]. In [P_{I}] region, V/G ratio ranges from the above-described (V/G)₁ to the critical point. In [Pv] region, V/G ratio ranges from the critical point to the above-described (V/G)₂. That is, [P_{I}] is a region that is adjacent to the region [I] and has a interstitial silicon type point defect concentration lower than the lowest concentration of interstitial silicon type point defects for forming a interstitial-type dislocation, and [Pᵥ] is a region that is adjacent to the region [V] and has a vacancy type point defect concentration lower than the lowest concentration of vacancy type point defects for forming an OSF. In the crystallization process, micro-defects constituting nuclei of the above-described OSF are introduced in the crystal, and the OSF appears, for example in a thermal oxidation process during a device production process, and causes malfunction such as increase of leak current in the produced device.

In FIG. 2, the center position 43a of the predetermined spacing T between the first coil and the second coil is controlled to be at the same or lower level as the surface of the silicon melt 12 such that 0 mm ≤|H| ≤ 10000 mm is satisfied, where H is a distance of the center position 43a from the surface of the silicon melt 12.
Where I₁ denotes the current energized in the first coil 41 and I₂ denotes the current 42 energized in the second coil, magnetic flux density at a position at the same level as the center position 43a and within the inner diameter of the quartz crucible 13 (a position in a plane which is surrounded by the inner wall of the quartz crucible 13 at the same level as the center position 43a) is controlled to be 0.001 to 0.1T (Wb/m²) by energizing electric currents in the first coil 41 and the second coil 42 such that I₁ and I₂ are controlled in the range from 0.1 to 10³⁰ A and satisfy 0.001 ≤ (I₁/I₂) ≤ 1.
Here the distance H of the center position 43a from the surface of the silicon melt 12 is specified to be in the above-described range since it is difficult to control the oxygen and the shape of the solid-liquid interface because of insufficient strength where H|exceeds 10000 mm. The electric currents in the first and second coils 41, 42 are controlled since the Lorentz force for generating convection in the silicon melt 12 must be increase with increasing diameter 13 of the quartz crucible. Where the currents are set to be outside the above-described ranges, the melt convection does not exhibit an ideal pattern and the solid-liquid interface cannot be controlled.

As described above, by controlling the center position 43a of the predetermined spacing T between the first coil 41 and the second coil 42, and by controlling the strength of the magnetic field 43, as shown in FIG. 2, predetermined convections 44, 45 are generated in the silicon melt. By these convections, the shape of solid-liquid interface 25a which largely had a downwardly convex shape in the prior art takes nearly flat shape at the same level as the melt surface. At that sate, the silicon single crystal ingot 25 is pulled while rotating the ingot at a predetermined rotation speed and rotating the quartz crucible 13 at a predetermined rotation speed. In this process, vertical thermal gradient G in the silicon single crystal ingot 25 shows uniform radial distribution. Thus, it is possible to reduce the variation in V/G along the radial distance. As a result, a silicon single crystal ingot 25 which is defect-free and of high quality throughout nearly the whole length can be produced relatively easily in accordance with the V/G model of Voronkov.

### INDUSTRIAL APPLICABILITY

By pulling a silicon single crystal using the apparatus for pulling a single crystal according to the present invention, it is possible to prevent impurities, for example, oxygen which is dissolved from the wall of the quartz crucible and contaminates in the melt, from concentrating to the central portion of the surface of the silicon melt. Therefore, the amount of oxygen as an impurity contaminated into the silicon single crystal can be reduced sufficiently.
In the apparatus for pulling a single crystal according to the present invention, it is possible to control the shape of solid-liquid interface directly beneath the silicon single crystal ingot. By pulling the silicon single crystal ingot from the silicon melt in accordance with a predetermined pulling rate profile, it is possible to produce a silicon single crystal ingot interior of which is free of aggregates of interstitial silicon type point defects.

## Claims

1. An apparatus for pulling a silicon single crystal comprising:
a quartz crucible which is installed in a chamber and stores a silicon melt, and is rotated at a predetermined rotation speed while a silicon single crystal being pulled from the silicon melt is rotated at a predetermined speed; and
a first coil and a second coil that are installed with a predetermined spacing in between in the vertical direction such that a center of each coil is adjusted to a rotation axis of the quartz crucible so as to generate a magnetic field between the first and the second coils by energizing electric current in each of the first coil and the second coil in the same direction while pulling the silicon single crystal ingot,
wherein the first coil is installed outside the chamber and the second coil is installed inside the chamber.

2. An apparatus for pulling a silicon single crystal according to claim 1,
wherein an spacing T between the first coil and the second coil is greater than 0 and less than or equal to 10000 mm,
a diameter D₁ of the first coil is 100 mm or more and 10000 mm or less,
a diameter D₂ of the second coil is 5 mm or more and 5000 mm or less,
a proportion of the diameter D₁ of the first coil to the diameter D₂ of the second coil is 1 or more and 2000 or less, and
a difference between the diameter D₁ of the first coil and the diameter D₂ of the second coil is not less than 2t, where t denotes a thickness of a circumferential wall of the chamber.

3. A method of pulling a silicon single crystal, comprising:
rotating a quartz crucible that is installed in a chamber and stores a silicon melt at a predetermined rotation speed;
rotating a silicon single crystal ingot being pulled from the silicon melt at a predetermined rotation speed;
installing a first coil having a diameter which is larger than a diameter of the chamber outside the chamber such that a center of the first coil corresponds to a rotation axis of the quartz crucible;
installing a second coil having a diameter which is smaller than the diameter of the chamber inside the chamber with a predetermined spacing T in the vertical direction from the first coil such that a center of the second coil corresponds to a rotation axis of the quartz crucible;
generating a magnetic field between the first and the second coils by energizing electric current in each of the first coil and the second coil in the same direction; and
pulling the single crystal ingot,
wherein a center position of the predetermined spacing T between the first coil and the second coil is controlled to be at the same or lower level as the surface of the silicon melt such that 0 mm ≤ | H | ≤ 10000 mm is satisfied, where H is a distance of the center position from the surface of the silicon melt.

4. A method of pulling a silicon single crystal ingot according to claim 3,
energizing electric currents in the first coil and the second coil such that I₁ and I₂ are controlled in the range from 0.1 to 10³⁰ A and satisfy 0.001 ≤ (I₁/I₂) ≤ 1, where I₁ denotes a current energized in the first coil and I₂ denotes a current energized in the second coil, and
controlling a magnetic flux density at a position at the same level as the center position and within the inner diameter of the quartz crucible to be 0.001 to 0.1 T (Wb/m²).
